# EUROPÄISCHE PATENTANMELDUNG

(11) **EP 4 576 956 A1**
(43) Veröffentlichungstag der Anmeldung: **25.06.2025**
(21) Anmeldenummer: 23219800.2
(22) Anmeldetag: 22.12.2023
(51) Int. Cl.: H05K 5/06

(54) **GEHÄUSE FÜR ELEKTRONISCHE KOMPONENTEN**

(71) Anmelder: FRONIUS INTERNATIONAL GmbH, 4643 Pettenbach (AT)
(72) Erfinder: HUEMER, Bernhard, 4643 Pettenbach (AT); MOSER, Peter, 4643 Pettenbach (AT)
(74) Vertreter: SONN Patentanwälte GmbH & Co KG

(57) **Zusammenfassung**

Die Erfindung betrifft ein Gehäuse (1) für elektronische Komponenten, insbesondere Photovoltaik-Wechselrichtergehäuse, mit zumindest zwei miteinander verbindbaren Gehäuseteilen (2, 3) und einem Dichtungsprofil (4) zur Abdichtung des Innenraums (I) des Gehäuses (1) gegenüber dem Außenraum (A) des Gehäuses (1), welches Dichtungsprofil (4) in zumindest einer Nut (5, 6) zumindest eines Gehäuseteils (2, 3) angeordnet ist. Erfindungsgemäß ist die zumindest eine Nut (5, 6) in zumindest einem Gehäuseteilen (2, 3) in Form einer offenen Strecke ausgebildet, wobei der Anfang (7, 9) und das Ende (8, 10) der zumindest einen Nut (5, 6) in einem Überlappungsbereich (11) mit einer vorbestimmten Länge (l_{U}) nebeneinander angeordnet ist, und das Dichtungsprofil (4) vorzugsweise klebefrei in der zumindest einen Nut (5, 6) angeordnet ist, und das Dichtungsprofil (4) zumindest über einen Teil der vorbestimmten Länge (l_{U}) des Überlappungsbereichs (11) berührend nebeneinander angeordnet ist.

## Beschreibung

Die Erfindung betrifft ein Gehäuse für elektronische Komponenten, insbesondere Photovoltaik-Wechselrichtergehäuse, mit zumindest zwei miteinander verbindbaren Gehäuseteilen und einem Dichtungsprofil zur Abdichtung des Innenraums des Gehäuses gegenüber dem Außenraum des Gehäuses, welches Dichtungsprofil in zumindest einer Nut zumindest eines Gehäuseteils angeordnet ist.

Grundsätzlich sind beliebige Gehäuse für elektronische Komponenten umfasst, welche eine Dichtung aufweisen, um den Innenraum des Gehäuses, also die entsprechende Elektronik, vor Einflüssen des Außenraums zu schützen. Im Allgemeinen besteht das Gehäuse aus zwei Gehäuseteilen, einem wannenförmigen Gehäuseteil und einem Deckel. Es sind verschiedenste Formen an Gehäusen denkbar, welche auch aus mehr als zwei Gehäuseteilen bestehen können. In erster Linie soll ein Eintritt von Staub in den Innenraum weitestgehend verhindert werden, um eine möglichst hohe Lebensdauer der jeweiligen elektronischen Komponenten gewährleisten zu können. Für manche Geräte, insbesondere solche, die im Freien aufgestellt werden müssen, können auch höhere Anforderungen gelten. Beispielsweise werden Photovoltaik-Wechselrichter häufig im Au-βenbereich platziert, wo sie teilweise enormen Temperaturschwankungen und anderen Umwelteinflüssen, wie zum Beispiel Regen und Stürmen, ausgesetzt sind. Aus diesem Grund müssen manche elektrischen Geräte bestimmte Normen oder Schutzklassen erfüllen. Beispielsweise gilt im Europäischen Raum für Photovoltaik-Wechselrichter häufig die Schutzklasse IP65 der Internationalen Elektrotechnischen Kommission (IEC 60529). Diese Schutzklasse fordert die höchste Klasse gegen den Eintritt von festen Fremdkörpern und einen hohen Schutz gegen einen leichten Druckwasserstrahl und andere Flüssigkeiten, also Staub- und Wasserdichtheit.

Zum Schutz elektronischer Gehäuse vor Staub und Wasser werden häufig Dichtungen zwischen den Gehäuseteilen des Gehäuses eingelegt. Auch bei Gehäusen von Photovoltaik-Wechselrichtern werden neben aufgesprühten Schaumdichtungen hauptsächlich Dichtungsprofile, insbesondere Hohlkammerprofildichtungen, verwendet, um den Innenraum des Gehäuses gegenüber dem Außenraum abzudichten. Dichtungsprofile haben gegenüber Schaumdichtungen den Vorteil einer Tauschmöglichkeit im Servicefall und einer hohen Zulässigkeit von Toleranzen zwischen den Komponenten. Damit solche Dichtungsprofile für Schutzklassen, beispielsweise die oben erwähnte IP65, geeignet sind, müssen diese in einem Ring angeordnet werden, dessen Enden verklebt werden. Im Falle einer Hohlkammerprofildichtung muss diese auch noch an der Innenseite des Gehäuses gelocht werden, um einen Druckausgleich zwischen der Hohlkammer und dem Innenraum des Gehäuses zu ermöglichen. Dementsprechend müssen die Dichtungsprofile in relativ genauer Länge vorliegen und die Enden exakt senkrecht geschnitten und miteinander verklebt werden. Nachträglich wird die Verklebung manuell geschliffen, damit das Dichtungsprofil im Bereich der Verklebung dicht an der zumindest einen Nut zumindest eines Gehäuseteils anliegt. Diese Arbeiten sind besonders arbeits- und kostenintensiv. Eine Automatisierung ist mit solchen Dichtungen schwer bzw. nicht umsetzbar.

Beispielsweise beschreibt die CN 21937229 U ein Gehäuse eines Photovoltaik-Wechselrichters, bei dem ein umlaufendes Dichtungsprofil in einer umlaufenden Nut eines Gehäuseteils angeordnet ist.

Aus der CN 217336182 U ist ebenfalls ein Gehäuse mit einem umlaufenden Dichtungsprofil bekannt geworden, mit einem speziellen Verlauf des Dichtungsprofil im Bereich der Bohrungen für die Anordnung von Schrauben zur Verbindung der Gehäuseteile. Über entsprechende konstruktive Elemente an den Gehäuseteilen wird das Dichtungsprofil in der gewünschten Position gehalten.

Die Aufgabe der vorliegenden Erfindung besteht in der Schaffung eines Gehäuses für elektronische Komponenten, insbesondere Photovoltaik-Wechselrichter, welches ausreichend dicht und gegebenenfalls entsprechend bestimmten Schutzklassen ausgeführt ist. Die Dichtungen sollen möglichst rasch und einfach, allenfalls auch automatisierbar, in die Gehäuseteile eingelegt werden können. Nachteile bekannter Gehäuse, insbesondere Photovoltaik-Wechselrichtergehäuse, sollen vermieden oder zumindest reduziert werden.

Gelöst wird die erfindungsgemäße Aufgabe durch ein oben genanntes Gehäuse, bei dem die zumindest eine Nut in zumindest einem Gehäuseteil in Form einer offenen Strecke ausgebildet ist, wobei der Anfang und das Ende der zumindest einen Nut in einem Überlappungsbereich mit einer vorbestimmten Länge nebeneinander angeordnet ist, und das Dichtungsprofil vorzugsweise klebefrei in der zumindest einen Nut und zumindest über einen Teil der vorbestimmten Länge des Überlappungsbereichs berührend nebeneinander angeordnet ist. Durch die überlappende Anordnung der zumindest einen Nut zumindest eines Gehäuseteils und somit der überlappenden Anordnung des Dichtungsprofils in der zumindest einen Nut ist kein umlaufendes, an den Enden in aufwendiger Weise verbundenes bzw. verklebtes Dichtungsprofil mehr notwendig und die entsprechenden Arbeitsschritte für die Bearbeitung und Verbindung der Ende des Dichtungsprofils und allfällige Nachbearbeitung der Verbindungsstelle können entfallen. Dennoch wird durch die Berührung der Enden des Dichtungsprofils zumindest über einen Teil der vorbestimmten Länge des Überlappungsbereichs eine Abdichtung des Innenraums des Gehäuses gegenüber dem Außenraum bei geschlossenem Gehäuse erzielt. Je nach Schutzklasse müssen gegebenenfalls noch weitere Maßnahmen zur Erfüllung gesetzt werden, welche weiter unten optional beschrieben werden. Für die sichere Anordnung des Dichtungsprofils in zumindest einem Gehäuseteil des Gehäuses ist zumindest eine Nut in einem Gehäuseteil notwendig. Der zumindest eine weitere Gehäuseteil kann auch ohne Nut entsprechend gestaltet werden, solange sichergestellt wird, dass bei verbundenen Gehäuseteilen und geschlossenem Gehäuse das Dichtungsprofil eng an den Gehäuseteilen anliegt. Es können aber auch beide oder mehrere Gehäuseteile des Gehäuses mit entsprechenden gegenüberliegenden Nuten versehen sein, sodass das Dichtungsprofil von den gegenüberliegenden Nuten der Gehäuseteile umfasst wird. Die Konstruktion des Gehäuses mit Anordnung der zumindest einen Nut in zumindest einem Gehäuseteil und entsprechend des Dichtungsprofils in Form einer offenen Strecke anstelle eines in sich geschlossenen Rings bringt eine Arbeitserleichterung mit sich und ermöglicht zudem eine automatisierte Anordnung des Dichtungsprofils an einem Gehäuseteil und gegebenenfalls auch die automatisierte Verbindung aller Gehäuseteile und somit das Verschließen des Gehäuses. Dadurch können weitere Kosten eingespart und Arbeitsschritte beschleunigt werden. Vorzugsweise erfolgt die Anordnung des Dichtungsprofils klebefrei, wodurch das Dichtungsprofil ohne großen Aufwand entnommen und beispielsweise getauscht werden kann. Ein weiterer Vorteil des offenen Dichtungsprofils ist eine höhere Toleranzzulässigkeit. Während beim Stand der Technik zu kurze in sich geschlossene Ringe des Dichtungsprofils nicht verwendet werden konnten, da sie nicht in die vorgegebene Nut passen, lässt die vorliegend Konstruktion des Gehäuses größere Toleranzen zu. Wenn das Dichtungsprofil zu kurz abgeschnitten wurde, würde nur der Bereich, in dem sich die Enden des Dichtungsprofils im Überlappungsbereich berühren, etwas kürzer ausfallen. Die Dichtheit des Gehäuses wäre aber dennoch gewährleistet, wenn die Länge der Berührung nicht unter ein bestimmtes Maß fällt. Unter Umständen kann es für manche Anwendungen dennoch von Vorteil oder sogar gefordert sein, die Dichtung zumindest stellenweise mit einem Gehäuseteil zu verkleben. Das Dichtungsprofil muss natürlich aus elastischem Material gebildet sein.

Vorteilhafterweise ist der Überlappungsbereich der Nuten und des Dichtungsprofils im Wesentlichen parallel zu einer Außenseite des Gehäuses im Überlappungsbereich angeordnet. Dadurch wird nur ein minimaler Innenraum des Gehäuses durch den Überlappungsbereich eingenommen.

Alternativ dazu kann der Überlappungsbereich auch im Wesentlichen senkrecht zu einer Außenseite des Gehäuses im Überlappungsbereich angeordnet sein. In diesem Fall wird zwar mehr Innenraum des Gehäuses durch den Überlappungsbereich eingenommen, dafür sind beide Enden des Dichtungsprofils nach Innen gerichtet, was für manche Anwendungen vorteilhaft sein kann.

Die vorbestimmte Länge des Überlappungsbereichs kann beispielsweise zwischen 10 mm und 80 mm betragen. Die Länge des Überlappungsbereichs soll jedenfalls gewährleisten, dass die Enden des Dichtungsprofils eine gewisse Mindestlänge nebeneinander berührend angeordnet sind, sodass zwischen den Dichtungsprofilen kein Staub oder keine Feuchtigkeit vom Außenraum des Gehäuses in den Innenraum eindringen kann und somit die geforderte Dichtheit erfüllt wird.

Gemäß einem weiteren Merkmal der Erfindung ist das Dichtungsprofil durch eine Hohlkammerprofildichtung mit zumindest einer in Längsrichtung durchgehenden Hohlkammer gebildet. Solche Hohlkammerprofile werden häufig für die Abdichtung von Gehäusen eingesetzt. Da das Hohlkammerprofil zumindest an einem Ende offen bleibt, ist über das offene Ende ein Druckausgleich mit der Umgebung möglich. Somit kann der bei in sich geschlossenen Hohlkammerprofildichtungen notwendige Schritt des Lochens der Hohlkammerprofildichtung entfallen. Das erleichtert den Zusammenbau des Gehäuses und senkt somit die Gesamtkosten noch weiter.

Wenn an der gegenüberliegenden Seite der zumindest einen Hohlkammer der Hohlkammerprofildichtung ein Klemmprofil angeordnet ist, lässt sich ein solches Dichtungsprofil besonders einfach und rasch in eine Nut eines Gehäuseteils des Gehäuses einlegen. Durch das geeignet gestaltete Klemmprofil, beispielsweise in Form mehrerer beidseitig abstehender Stege, hält die Hohlkammerprofildichtung automatisch und ohne Notwendigkeit eines Klebstoffs ausreichend fest in der Nut eines Gehäuseteils.

Der Anfang der Hohlkammerprofildichtung im Überlappungsbereich ist idealerweise zum Außenraum des Gehäuses hin angeordnet und verschlossen und das Ende der Hohlkammerprofildichtung im Überlappungsbereich zum Innenraum des Gehäuses hin angeordnet und offen. Durch den verschlossenen Anfang der Hohlkammerprofildichtung wird das Eindringen von Feuchtigkeit von Außen in die zumindest eine Hohlkammer der Hohlkammerprofildichtung verhindert. Andererseits ermöglicht das in den Innenraum des Gehäuses weisende offene Ende der Hohlkammerprofildichtung einen Druckausgleich zwischen der Hohlkammer und dem Innenraum des Gehäuses. Somit kann die bereits oben beschriebene Lochung der Hohlkammerprofildichtung für den Druckausgleich unterbleiben. Insbesondere bei sehr starken Temperaturschwankungen in der Umgebung des Gehäuses kann der Druckausgleich besonders wichtig sein. Um einen Druckausgleich auch zwischen dem Innenraum und dem Außenraum des geschlossenen Gehäuses zu ermöglichen, können zusätzliche Druckausgleichsventile am Gehäuse angeordnet sein.

Dabei ist der Anfang der Hohlkammerprofildichtung vorzugsweise durch Klemmung verschlossen. Eine solche Klemmung kann besonders rasch und einfach vorgenommen werden und erfordert im Wesentlichen keine vorherige Bearbeitung der Hohlkammerprofildichtung.

Diese Klemmung des Anfangs der Hohlkammerprofildichtung kann in besonders geeigneter Weise durch einen Fortsatz in der Nut eines Gehäuseteils und durch ein Gegenstück am anderen Gehäuseteil gebildet sein. Somit wird der Anfang der Hohlkammerprofildichtung automatisch beim Befestigen der Gehäuseteile bzw. beim Schließen des Gehäuses geklemmt und somit verschlossen. Notwendig ist nur eine entsprechende Konstruktion des erwähnten Fortsatzes und des Gegenstücks am anderen Gehäuseteil. Idealerweise wird der Fortsatz und das Gegenstück gleich in den jeweiligen Gehäuseteilen integriert und beim Herstellungsvorgang (beispielsweise durch ein Spritzgießverfahren oder Gießverfahren) berücksichtigt.

Bei geschlossenem Gehäuse beträgt der Abstand zwischen dem oben genannten Fortsatz und dem Gegenstück zwischen 20% und 50% der Höhe der Hohlkammerprofildichtung. Dieser Grad an Klemmung reicht üblicherweise für einen sicheren Verschluss des Anfangs der Hohlkammerprofildichtung und der darin angeordneten zumindest einen Hohlkammer. Unter der Höhe der Hohlkammerprofildichtung wird die Höhe des Querschnitts der Hohlkammerprofildichtung ohne allfälliges Klemmprofil verstanden.

Wenn zwischen den Nuten eines Gehäuseteils im Überlappungsbereich zumindest ein Druckelement, insbesondere ein Drucksteg, angeordnet ist, können der Anfang und das Ende des Dichtungsprofils im Überlappungsbereich etwas gequetscht und damit aneinandergepresst werden. Dies gewährleistet eine gute Abdichtung des Raumes zwischen den einander überlappenden Enden des Dichtungsprofils im Überlappungsbereich.

Wenn der Anfang der Hohlkammerprofildichtung stufenförmig geschnitten ist, sodass der Teil der Hohlkammerpofildichtung mit der zumindest einen Hohlkammer über das Klemmprofil hervorsteht, kann der Bereich der Hohlkammerprofildichtung, in der die zumindest eine Hohlkammer angeordnet ist, durch die oben beschriebenen Maßnahmen optimal geklemmt und somit die zumindest eine Hohlkammer verschlossen werden. Das stufenförmige Schneiden der Hohlkammerprofildichtung erfolgt vorzugsweise auch automatisch. Das Ende des Hohlkammerprofils kann ebenfalls mit dem stufenförmigen Schnitt versehen bleiben, auch wenn dort eine Klemmung des Endes der Hohlkammerprofildichtung nicht notwendig ist. Es kann aber ein Verschnitt vermieden und ein weiterer Arbeitsschritt bei dem das Ende der Hohlkammerprofildichtung eben abgeschnitten würde, entfallen.

Im Bereich des Anfangs einer Nut eines Gehäuseteils kann eine Markierung angeordnet sein, welche die Stelle kennzeichnet, an der das Dichtungsprofil eingelegt werden soll. Die Markierung, welche durch eine Kerbe oder einen vorzugsweise farbigen Strich oder dgl. gebildet sein kann, zeigt dem Monteur beim manuellen Einlegen des Dichtungsprofils somit an, wo der Beginn des Dichtungsprofils platziert werden soll, bevor das Dichtungsprofil in die Nut eingelegt wird, bis das Ende des Dichtungsprofils wieder an der gewünschten Stelle im Überlappungsbereich endet. Natürlich kann die Markierung auch für Manipulatoren oder Roboter ausgelegt sein und eine Unterstützung bieten.

Wenn die zumindest eine Nut zumindest eines Gehäuseteils im Überlappungsbereich außen durch eine Wand begrenzt ist, kann das Einlegen des Dichtungsprofils erleichtert und ein unerwünschtes Austreten des Dichtungsprofils aus der Nut im Überlappungsbereich erschwert werden. Insbesondere beim automatischen Einlegen des Dichtungsprofils mit entsprechenden Manipulatoren oder Robotern kann eine solche Wand hilfreich sein.

Das Einlegen des Dichtungsprofils, insbesondere das automatisierte Einlegen, kann weiter unterstützt werden, wenn die zumindest eine Nut zumindest eines Gehäuseteils an der Innenseite einer Kurve durch eine Wand begrenzt ist. Die Wand bildet demnach in den Kurven eine Art Führung für das Dichtungsprofil beim Einlegevorgang.

Bei vertikaler Anordnung des Gehäuses in einer Gebrauchslage ist es von Vorteil, wenn der Anfang der Hohlkammerprofildichtung nach unten weisend angeordnet ist. Dies stellt sicher, dass Feuchtigkeit schwerkraftbedingt nicht in eine Hohlkammer der Hohlkammerprofildichtung eindringen kann, wenn diese beispielsweise durch unzureichende Klemmung nicht vollständig verschlossen ist.

Das Dichtungsprofil ist vorzugsweise aus Kunststoff, insbesondere aus Silikon, gebildet. Vorausgesetzt wird eine gewisse Elastizität des Materials und eine hohe Lebensdauer. Insbesondere beim Einsatz in Photovoltaik-Wechselrichtergehäusen ist auch eine hohe Temperaturbeständigkeit gefordert. Neben Kunststoffen kommen für das Dichtungsprofil auch natürliche Materialien, wie zum Beispiel Kautschuk, in Frage.

Wie bereits erwähnt, ist es von Vorteil, wenn das Dichtungsprofil automatisiert in eine Nut eines Gehäuseteils einlegbar ist, da somit Zeit und Kosten bei der Zusammenstellung des Gehäuses gespart werden kann.

Die zumindest zwei Gehäuseteile können in herkömmlicher Weise durch Schrauben oder Schnellverschlüsse miteinander verbindbar sein. Die Schrauben, Schnellverschlüsse oder anderen Befestigungselemente sollen eine möglichst rasche und sichere Verbindung der Gehäuseteile und somit ein Schließen des Gehäuses ermöglichen. Um sicherzustellen, dass die Befestigungselemente ausreichend fest sitzen, können Rastelemente vorgesehen werden, welche den ordnungsgemäßen Verschluss haptisch und allenfalls auch akustisch signalisieren.

Zumindest ein Gehäuseteil kann aus Metall, insbesondere aus Aluminium oder einer Aluminiumlegierung, oder aus Kunststoff, insbesondere aus Thermoplasten, bestehen. Beispielsweise kann ein Gehäuseteil aus Polyamid oder Polycarbonat hergestellt werden.

Die vorliegende Erfindung wird anhand der beigefügten Zeichnungen näher erläutert. Darin zeigen:
- Fig. 1: eine erste Ausführungsform eines erfindungsgemäßen Gehäuses mit geöffneten Gehäuseteilen;
- Fig. 2: eine zweite Ausführungsform eines erfindungsgemäßen Gehäuses mit geöffneten Gehäuseteilen;
- Fig. 3A und 3B: eine Stirnansicht und ein seitliches Schnittbild des Endes einer üblichen Hohlkammerprofildichtung;
- Fig. 4A und 4B: Detailansichten auf die Nuten der beiden Gehäuseteile im Überlappungsbereich;
- Fig. 5: ein Schnittbild durch einen Teil eines zusammengebauten Gehäuses im Überlappungsbereich entlang der Schnittlinie V - V in Figur 4A;
- Fig. 6: ein Schnittbild durch einen Teil eines zusammengebauten Gehäuses im Überlappungsbereich entlang der Schnittlinie VI - VI in Figur 4A;
- Fig. 7: eine perspektivische Ansicht auf einen Gehäuseteil im Überlappungsbereich der Nut, wobei Wände zum erleichterten Einlegen des Dichtungsprofils vorgesehen sind; und
- Fig. 8: eine perspektivische Ansicht auf einen Gehäuseteil im Bereich einer Kurve der Nut mit einer innenseitig der Nut angeordneten Wand zum erleichterten Einlegen des Dichtungsprofils.

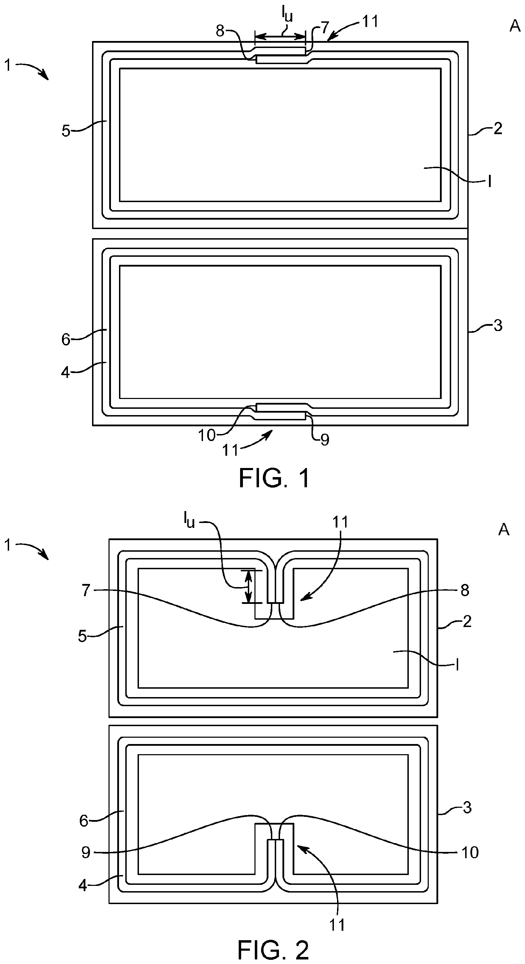

Fig. 1 zeigt eine erste Ausführungsform eines erfindungsgemäßen Gehäuses 1 mit zwei geöffneten Gehäuseteilen 2, 3. Das Gehäuse 1 dient der Aufnahme und dem Schutz elektronischer Komponenten, wie zum Beispiel einem Photovoltaik-Wechselrichter (nicht dargestellt). Die beiden Gehäuseteile 2, 3 können in üblicher Weise mit entsprechenden Befestigungselementen, wie zum Beispiel Schrauben oder Schnellverschlüssen oder dgl. (nicht dargestellt) miteinander verbunden werden. Damit der Innenraum I des Gehäuses 1 in geschlossenem Zustand gegenüber dem Außenraum A abgedichtet um die darin angeordneten elektronischen Komponenten vor Umwelteinflüssen zu schützen, wird ein Dichtungsprofil 4 aus elastischem Material zwischen den beiden Gehäuseteilen 2, 3 angeordnet. In zumindest einem oder beiden Gehäuseteil(en) 2, 3 ist eine Nut 5, 6 angeordnet, in welche das Dichtungsprofil 4 bei verbundenen Gehäuseteilen 2, 3 eingelegt ist. Beim Stand der Technik handelt es sich meist um ein umlaufendes, also in sich geschlossenes Dichtungsprofil 4 (nicht dargestellt). Die Anfertigung und Anordnung eines solchen umlaufenden Dichtungsprofils 4 ist mit entsprechendem Aufwand verbunden.

Beim erfindungsgemäßen Gehäuse 1 ist die zumindest eine Nut 5, 6 in zumindest einem Gehäuseteil 2, 3 in Form einer offenen Strecke ausgebildet, also nicht in sich geschlossen. Im dargestellten Ausführungsbeispiel ist in jedem Gehäuseteil 2, 3 eine Nut 5, 6 vorgesehen, welche im zusammengesetzten Zustand der Gehäuseteile 2, 3 übereinstimmen. Es ist auch ein Gehäuse 1 möglich, bei dem nur in einem Gehäuseteil 2 oder 3 eine Nut 5 oder 6 angeordnet ist und das andere Gehäuseteil 3 oder 2 eben ausgeführt wird. Beim geschlossenen Gehäuse 1 ist das Dichtungsprofil 4 dann in beiden Nuten 5, 6 eingelegt und dichtet somit den Innenraum I des Gehäuses 1 gegenüber dem Außenraum A entsprechend ab. Der Anfang 7 und das Ende 8 der Nut 5 des Gehäuseteils 2 sowie der Anfang 9 und das Ende 10 der Nut 6 des Gehäuseteils 3 ist in einem Überlappungsbereich 11 mit einer vorbestimmten Länge l_{U} nebeneinander angeordnet. Somit kann das offene Dichtungsprofil 4 in die Nut 5 oder 6 des Gehäuseteils 2 oder 3 eingelegt werden, ohne dass ein geschlossenes Dichtungsprofil 4 angefertigt werden muss. Die erforderliche Abdichtung des Innenraums I des geschlossenen Gehäuses 1 gegenüber dem Außenraum A wird dadurch gewährleistet, dass das Dichtungsprofil 4 zumindest über einen Teil der vorbestimmten Länge l_{U} des Überlappungsbereichs 11 berührend nebeneinander angeordnet ist. Das Dichtungsprofil 4 wird vorzugsweise klebefrei in der zumindest einen Nut 5, 6 angeordnet, sodass es einfach entfernt und beispielsweise ausgetauscht werden kann. Die Form der Nut 5, 6 und der Querschnitt des Dichtungsprofil 4 wird entsprechend aufeinander abgestimmt.

Im dargestellten Ausführungsbeispiel ist der Überlappungsbereich 11 im Wesentlichen parallel zu einer Außenseite des Gehäuses 1 im Überlappungsbereich 11 angeordnet. Dadurch wird der Innenraum I des Gehäuses 1 durch den Überlappungsbereich 11 kaum eingeschränkt oder verkleinert. Der Überlappungsbereich 11 kann somit am Rand der Gehäuseteile 2, 3 untergebracht werden. Der Rand der Gehäuseteile 2, 3 kann zumindest im Überlappungsbereich 11 allenfalls etwas breiter ausgeführt werden (nicht dargestellt).

Fig. 2 zeigt eine zweite Ausführungsform eines erfindungsgemäßen Gehäuses 1 mit geöffneten Gehäuseteilen 2, 3. Bei dieser Variante ist der Überlappungsbereich 11 im Wesentlichen senkrecht zu einer Außenseite des Gehäuses 1 im Überlappungsbereich 11 angeordnet. In diesem Fall wird zwar mehr Innenraum I des Gehäuses 1 durch den Überlappungsbereich 11 eingenommen, dafür ist der Anfang 7, 9 und das Ende 8, 10 der Nuten 5, 6 der Gehäuseteile 2, 3 und somit die Enden des Dichtungsprofils 4 beim geschlossenen Gehäuse 1 (nicht dargestellt) zum Innenraum I hin angeordnet, was für manche Anwendungen vorteilhaft sein kann.

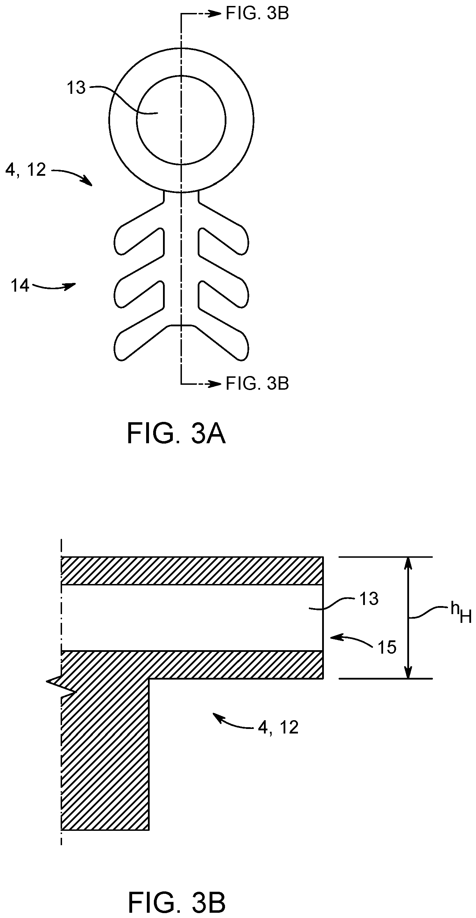

Fig. 3A zeigt eine Stirnansicht und Figur 3B ein seitliches Schnittbild entlang der Schnittlinie III-III in Fig. 3A durch das Ende einer üblichen Hohlkammerprofildichtung 12 als Dichtungsprofil 4. Die Hohlkammerprofildichtung 12 weist eine in Längsrichtung durchgehende Hohlkammer 13 auf. An der gegenüberliegenden Seite der Hohlkammer 13 der Hohlkammerprofildichtung 12 ist ein Klemmprofil 14 angeordnet. Das Klemmprofil 14 kann verschiedenartig gestaltet sein, um einen guten Halt der Hohlkammerprofildichtung 12 in einer geeigneten Nut (nicht dargestellt) auch ohne Notwendigkeit eines Klebstoffs gewährleisten zu können. Beispielsweise können mehrere (hier drei) beidseitig abstehende Stege vorgesehen sein, sodass ein Tannenbaum-artiges Klemmprofil 14 entsteht.

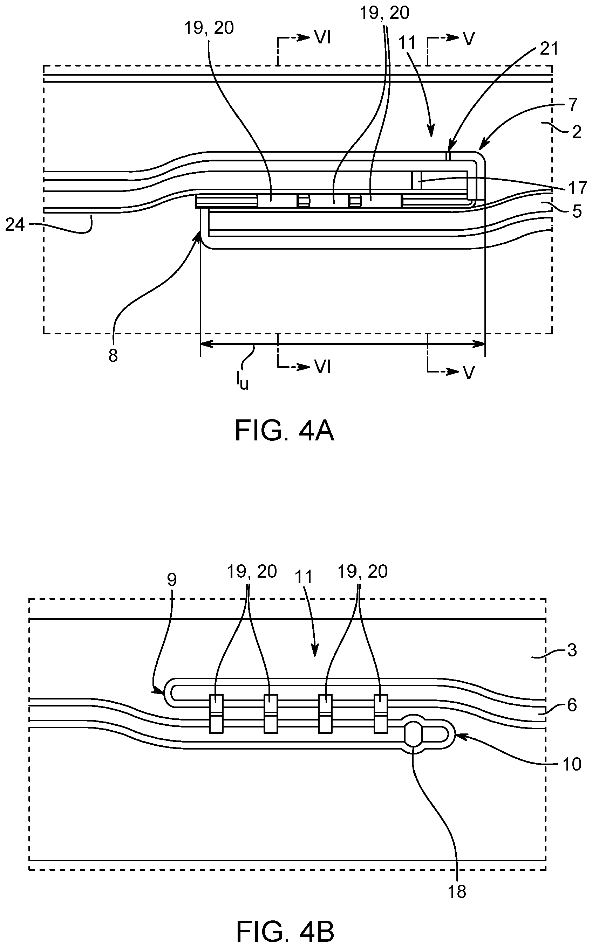

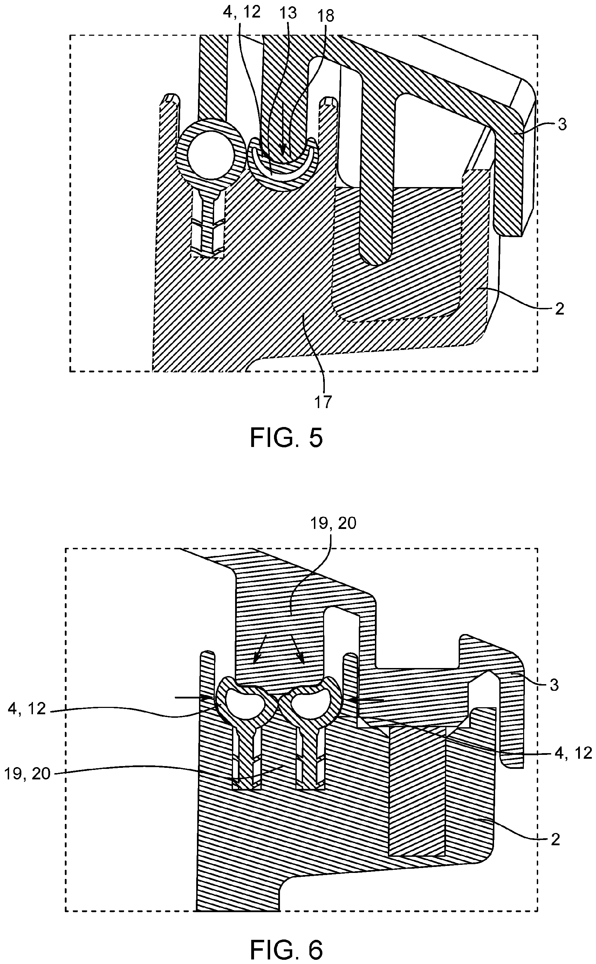

Wie in Fig. 3B ersichtlich, ist der Anfang 15 der Hohlkammerprofildichtung 12 stufenförmig geschnitten, sodass der Teil der Hohlkammerpofildichtung 12 mit der Hohlkammer 13 über das Klemmprofil 14 hervorsteht. Dadurch kann der Bereich der Hohlkammerprofildichtung 12, in der die Hohlkammer 13 angeordnet ist, optimal geklemmt werden. Bei der Klemmung des Anfangs 15 der Hohlkammerprofildichtung 12 wird die Höhe h_{H} der Hohlkammerprofildichtung 12 ohne Klemmprofil 14 entsprechend verringert, sodass die Hohlkammer 13 verschlossen wird. Die Klemmung der Hohlkammerprofildichtung 12 wird anhand der Figuren 4A, 4B und 5 noch detaillierter erklärt.

Fig. 4A und 4B zeigen Detailansichten auf die Nuten 5, 6 der beiden Gehäuseteile 2, 3 im Überlappungsbereich 11. Fig. 4A zeigt die Nut 5 des Gehäuseteils 2 und Fig. 4B die Nut 6 im Gehäuseteil 3 im Überlappungsbereich 11. Dementsprechend ist der Anfang 7 und das Ende 8 der Nut 5 und der Anfang 9 und das Ende 10 der Nut 6 im Überlappungsbereich 11 mit der vorbestimmten Länge l_{U} nebeneinander angeordnet. Das Dichtungsprofil 4 ist zumindest über einen Teil der vorbestimmten Länge l_{U} des Überlappungsbereichs 11 berührend nebeneinander angeordnet (siehe Fig. 6). Zum Klemmen des Anfangs 15 einer Hohlkammerprofildichtung 12 ist in der Nut 5 des Gehäuseteils 2 ein Fortsatz 17 angeordnet und am anderen Gehäuseteil 3 ein entsprechendes Gegenstück 18. Im Schnittbild Fig. 5 entlang der Schnittlinie V - V in Fig. 4A ist die Klemmung der Hohlkammerprofildichtung 12 zwischen dem Fortsatz 17 und dem Gegenstück 18 deutlicher zu erkennen.

Weiters können zwischen den Nuten 6 eines Gehäuseteils 3 im Überlappungsbereich 11 Druckelemente 19, insbesondere Druckstege 20, angeordnet sein, durch welche der Anfang und das Ende des Dichtungsprofils 4 bzw. der Hohlkammerprofildichtung 12 im Überlappungsbereich 11 etwas gequetscht und damit aneinandergepresst werden. Dies gewährleistet eine gute Abdichtung des Raumes zwischen den überlappenden Enden des Dichtungsprofils 4 im Überlappungsbereich 11 (siehe Schnittbild Fig. 6 entlang der Schnittlinie VI - VI in Fig. 4A).

Im Bereich des Anfangs 7 der Nut 5 des Gehäuseteils 2 kann eine Markierung 21 angeordnet sein. Eine solche Markierung 21, welche durch eine Kerbe oder einen vorzugsweise farbigen Strich oder dgl. gebildet sein kann, wird dem Monteur beim manuellen Einlegen des Dichtungsprofils 4 angezeigt, wo der Beginn des Dichtungsprofils 4 platziert werden soll, bevor das Dichtungsprofil 4 in die Nut 5 eingelegt wird. Die Markierung 21 kann aber auch für Roboter ausgelegt sein und beispielsweise über Kameras erfasst werden.

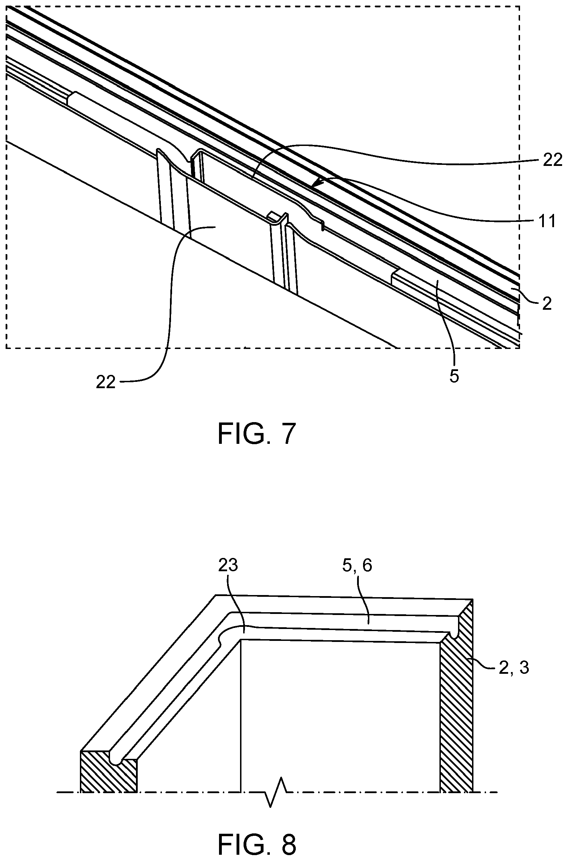

Fig. 7 zeigt eine perspektivische Ansicht auf einen Gehäuseteil 2 im Überlappungsbereich 11 der Nut 5, wobei Wände 22 zum erleichterten Einlegen des Dichtungsprofils 4 vorgesehen sind. Durch die Wände 22 kann auch ein unerwünschtes Austreten des Dichtungsprofils 4 aus der Nut 5 im Überlappungsbereich 11 erschwert werden.

Fig. 8 zeigt eine perspektivische Ansicht auf einen Gehäuseteil 2 oder 3 im Bereich einer Kurve der Nut 5 oder 6 mit einer innenseitig der Nut 5 oder 6 angeordneten Wand 23 zum erleichterten Einlegen des Dichtungsprofils 4 (nicht dargestellt). Insbesondere bei einem automatisierten Einlegen des Dichtungsprofils 4 kann eine solche Wand 23 hilfreich sein.

Die erfindungsgemäße Gestaltung des Gehäuses 1 erleichtert die Anordnung eines Dichtungsprofils 4 und senkt somit den Aufwand und die Kosten beim Zusammenbau des Gehäuses 1 für elektronische Komponenten, insbesondere von Photovoltaik-Wechselrichtern, welche bestimmte Schutzklassen (z.B. IP65) erfüllen müssen.

## Patentansprüche

1. Gehäuse (1) für elektronische Komponenten, insbesondere Photovoltaik-Wechselrichtergehäuse, mit zumindest zwei miteinander verbindbaren Gehäuseteilen (2, 3) und einem Dichtungsprofil (4) zur Abdichtung des Innenraums (I) des Gehäuses (1) gegenüber dem Außenraum (A) des Gehäuses (1), welches Dichtungsprofil (4) in zumindest einer Nut (5, 6) zumindest eines Gehäuseteils (2, 3) angeordnet ist, **dadurch gekennzeichnet, dass** die zumindest eine Nut (5, 6) in zumindest einem Gehäuseteil (2, 3) in Form einer offenen Strecke ausgebildet ist, wobei der Anfang (7, 9) und das Ende (8, 10) der zumindest einen Nut (5, 6) in einem Überlappungsbereich (11) mit einer vorbestimmten Länge (l_{U}) nebeneinander angeordnet ist, und das Dichtungsprofil (4) vorzugsweise klebefrei in der zumindest einen Nut (5, 6) und zumindest über einen Teil der vorbestimmten Länge (l_{U}) des Überlappungsbereichs (11) berührend nebeneinander angeordnet ist.

2. Gehäuse (1) nach Anspruch 1, **dadurch gekennzeichnet, dass** der Überlappungsbereich (11) im Wesentlichen parallel zu einer Außenseite des Gehäuses (1) im Überlappungsbereich (11) angeordnet ist.

3. Gehäuse (1) nach Anspruch 1, **dadurch gekennzeichnet, dass** der Überlappungsbereich (11) im Wesentlichen senkrecht zu einer Außenseite des Gehäuses (1) im Überlappungsbereich (11) angeordnet ist.

4. Gehäuse (1) nach einem der Ansprüche 1 bis 3, **dadurch gekennzeichnet, dass** das Dichtungsprofil (4) durch eine Hohlkammerprofildichtung (12) mit zumindest einer in Längsrichtung durchgehenden Hohlkammer (13) gebildet ist.

5. Gehäuse (1) nach Anspruch 4, **dadurch gekennzeichnet, dass** an der gegenüberliegenden Seite der zumindest einen Hohlkammer (13) der Hohlkammerprofildichtung (12) ein Klemmprofil (14) angeordnet ist.

6. Gehäuse (1) nach Anspruch 4 oder 5, **dadurch gekennzeichnet, dass** der Anfang (15) der Hohlkammerprofildichtung (12) im Überlappungsbereich (11) zum Außenraum (A) des Gehäuses (1) hin angeordnet und verschlossen ist und das Ende (16) der Hohlkammerprofildichtung (12) im Überlappungsbereich (11) zum Innenraum (I) des Gehäuses (1) hin angeordnet und offen ist.

7. Gehäuse (1) nach Anspruch 6, **dadurch gekennzeichnet, dass** der Anfang (15) der Hohlkammerprofildichtung (12) durch Klemmung verschlossen ist.

8. Gehäuse (1) nach Anspruch 7, **dadurch gekennzeichnet, dass** die Klemmung des Anfangs (15) der Hohlkammerprofildichtung (12) durch einen Fortsatz (17) in einer Nut (5, 6) eines Gehäuseteils (2, 3) und durch ein Gegenstück (18) am anderen Gehäuseteil (3, 2) gebildet ist.

9. Gehäuse (1) nach einem der Ansprüche 1 bis 8, **dadurch gekennzeichnet, dass** zwischen den Nuten (5, 6) eines Gehäuseteils (2, 3) im Überlappungsbereich (11) zumindest ein Druckelement (19), insbesondere ein Drucksteg (20), angeordnet ist.

10. Gehäuse (1) nach einem der Ansprüche 4 bis 9, **dadurch gekennzeichnet, dass** der Anfang (15) der Hohlkammerprofildichtung (12) stufenförmig geschnitten ist, sodass der Teil der Hohlkammerpofildichtung (12) mit der zumindest einen Hohlkammer (13) über das Klemmprofil (14) hervorsteht.

11. Gehäuse (1) nach einem der Ansprüche 1 bis 10, **dadurch gekennzeichnet, dass** im Bereich des Anfangs (7, 9) einer Nut (5, 6) eines Gehäuseteils (2, 3) eine Markierung (21) angeordnet ist.

12. Gehäuse (1) nach einem der Ansprüche 1 bis 11, **dadurch gekennzeichnet, dass** die zumindest eine Nut (5, 6) zumindest eines Gehäuseteils (2, 3) im Überlappungsbereich (11) außen durch eine Wand (22) begrenzt ist.

13. Gehäuse (1) nach einem der Ansprüche 1 bis 12, **dadurch gekennzeichnet, dass** die zumindest eine Nut (5, 6) zumindest eines Gehäuseteils (2, 3) an der Innenseite einer Kurve durch eine Wand (23) begrenzt ist.

14. Gehäuse (1) nach einem der Ansprüche 4 bis 13, **dadurch gekennzeichnet, dass** bei vertikaler Anordnung des Gehäuses (1) in einer Gebrauchslage der Anfang (15) der Hohlkammerprofildichtung (12) nach unten weisend angeordnet ist.

15. Gehäuse (1) nach einem der Ansprüche 1 bis 14, **dadurch gekennzeichnet, dass** das Dichtungsprofil (4) automatisiert in eine Nut (5, 6) eines Gehäuseteils (2, 3) einlegbar ist.
